# EUROPEAN PATENT APPLICATION

(11) **EP 4 718 964 A1**
(43) Date of publication of application: **01.04.2026**
(21) Application number: 24810802.9
(22) Date of filing: 19.04.2024
(51) Int. Cl.: H05K 9/00, B32B 7/025, H01F 1/10, H01F 1/34

(54) **ELECTROMAGNETIC WAVE SHIELDING MATERIAL**

(30) Priority: 23.05.2023 JP 2023084359
(71) Applicant: Toda Kogyo Corp., Hiroshima-shi, Hiroshima 732-0828 (JP)
(72) Inventor: TERANISHI, Manabu, Otake-shi, Hiroshima 739-0652 (JP); KIMURA, Tetsuya, Otake-shi, Hiroshima 739-0652 (JP); ISHIBASHI, Harutaka, Otake-shi, Hiroshima 739-0652 (JP); OHMAE, Satoshi, Otake-shi, Hiroshima 739-0652 (JP); YOSHIDA, Akihiro, Otake-shi, Hiroshima 739-0652 (JP)
(74) Representative: Greaves Brewster LLP
(86) International application number: PCT/JP2024/015628
(87) International publication number: WO 2024/241794

(57) **Abstract**

An electromagnetic wave shielding material (1) according to the present disclosure includes: magnetic layer (30) including a magnetic material; and conductive meshes (20) disposed on both surfaces of the magnetic layer (30).

## Description

### TECHNICAL FIELD

The present disclosure relates to an electromagnetic wave shielding material having an excellent magnetic field shielding effect in a wide frequency range.

### BACKGROUND ART

Rapidly growing use of various electronic devices in recent years leads to concern that electromagnetic wave noises and/or magnetic noises generated from these devices may cause malfunctions and/or defects of other electronic devices. Therefore, a widely employed countermeasure against such electromagnetic wave noises and/or magnetic noises is a method which includes providing a shielding material having the effect of shielding the electromagnetic wave noises and/or the magnetic noises for electronic components, cables, and the like.

A known example of such a shielding material as described above is an electromagnetic wave shielding material including a conductive layer and an insulating layer stacked one on top of another, where examples of the conductive layer include a metal mesh and a metal foil, and examples of the insulating layer include a synthetic resin. Since the conductive layer has an electric field shielding property, such an electromagnetic wave shielding material can shield the electric field noises. Moreover, various types of electromagnetic wave shielding materials including such a conductive layer and a magnetic layer stacked one on top of another to have the effect of also shielding the magnetic noises have been proposed, the magnetic layer including a magnetic material having an excellent magnetic property. A known electromagnetic wave shielding material disclosed in, for example, Patent Literature 1 is an electromagnetic wave shielding material including a conductive layer and a ferrite sintered body as a magnetic layer stacked one on top of another. Specifically, this electromagnetic wave shielding material has a structure including a first covering layer, a second covering layer, and a sheet-like ferrite sintered body sandwiched between the first covering layer and the second covering layer, wherein at least one of a top surface or a back surface of the sheet-like ferrite sintered body has a plurality of split grooves extending in longitudinal and transverse directions in a grid pattern, and at least one of the first covering layer or the second covering layer is a conductive layer formed from an electrically conductive material. Thus, a good shielding effect can be obtained.

Further, Patent Literature 2 discloses an electromagnetic wave shielding material including: a metal foil including non-magnetic metal; and a magnetic layer including an oxide magnetic body, wherein the metal foil and the magnetic layer are stacked one on top of another into one piece. Patent Literature 2 further describes that the electromagnetic wave shielding material may have a metal braided body outside or inside thereof.

### CITATION LIST

### PATENT LITERATURE

[Patent Literature 1] Japanese Laid-Open Patent Publication No. 2008-124197
[Patent Literature 2] Japanese Laid-Open Patent Publication No. 2022-155716

### SUMMARY OF INVENTION

### TECHNICAL PROBLEM

Electromagnetic wave shielding materials as described in Patent Literatures 1 and 2 are assumed to provide a good shielding effect by the conductive layer and the magnetic layer stacked one on top of another. However, an electromagnetic wave shielding material having an excellent magnetic field shielding effect in a wide frequency range is still in demand.

In view of the foregoing, it is an object of the present invention to provide an electromagnetic wave shielding material having an enhanced magnetic field shielding effect in a wide frequency range.

### SOLUTION TO PROBLEM

To achieve the object, the present invention has a configuration in which a magnetic layer including a magnetic material is sandwiched within conductive mesh(es).

Specifically, an electromagnetic wave shielding material according to the present disclosure includes: a magnetic layer including a magnetic material; and conductive meshes disposed on both surfaces of the magnetic layer.

The electromagnetic wave shielding material according to the present disclosure includes the conductive meshes, and the conductive meshes can thus impart an excellent electromagnetic shielding property to the electromagnetic wave shielding material. Further, the electromagnetic wave shielding material according to the present invention includes the magnetic layer including the magnetic material and thus has a magnetic field shielding effect. Furthermore, the conductive meshes are disposed on both the surfaces of the magnetic layer, and thereby, the magnetic layer is sandwiched within the conductive meshes, and thus, both the surfaces of the magnetic layer are electrically conductive. This suppresses noises from leaking and can thus enhance the magnetic field shielding effect of the electromagnetic wave shielding material. Thus, in the electromagnetic wave shielding material according to the present invention, the conductive meshes and the magnetic layer both contribute to noise shielding, which enables the magnetic field shielding effect in a wide frequency range to be enhanced.

In the electromagnetic wave shielding material according to the present disclosure, the conductive mesh disposed on one of both the surfaces and the conductive mesh disposed on the other of both the surfaces are preferably conductively connected to each other at both ends of the magnetic layer in a longitudinal direction or a width direction.

This enables surroundings of the magnetic layer to continuously be made electrically conductive and thus enables the magnetic field shielding effect of the electromagnetic wave shielding material to be further enhanced.

In the electromagnetic wave shielding material according to the present disclosure, when the conductive mesh disposed on one of both the surfaces and the other conductive mesh disposed on the other of both the surfaces are conductively connected to each other at both ends of the magnetic layer in a longitudinal direction or a width direction, the conductive meshes are preferably provided as a conductive mesh having a tubular or bag shape, and the magnetic layer is preferably housed inside the conductive mesh.

This enables surroundings of the magnetic layer to continuously be made electrically conductive and thus enables the magnetic field shielding effect of the electromagnetic wave shielding material to be further enhanced. Moreover, the magnetic layer is housed inside the conductive mesh having the tubular or bag shape, and thereby, the conductive meshes and the magnetic layer do not have to be fixed to each other and can be stacked one on top of another while the degree of freedom of moving relative to each other is maintained. Therefore, the electromagnetic wave shielding material can be resistant to fracture or the like caused by deformation and can have excellent flexibility.

In the electromagnetic wave shielding material according to the present disclosure, as the magnetic layer, a magnetic sheet may be used. Examples usable as the magnetic sheet include a ferrite sintered plate, an alloy plate, a sheet-shaped item obtained by molding a mixture of ferrite or metal magnetic powder and resin or rubber, and a base material coated with a coating material including magnetic powder. Examples of a soft magnetic material of the sheet include a Ni-Zn-Cu ferrite, a Mn-Zn ferrite, an amorphous alloy, Permalloy, electromagnetic steel, silicon steel, a sendust alloy, a Fe-Si alloy, a Fe-Al alloy, carbonyl iron, and reduced iron. Examples of a hard magnetic material of the sheet include a magnetoplumbite ferrite.

Further, in the electromagnetic wave shielding material according to the present disclosure, the magnetic material is preferably a ferrite sintered plate. The ferrite sintered plate is known for high magnetic permeability, and therefore, the magnetic layer can exhibit an excellent magnetic property. Moreover, the excellent magnetic property can be exhibited in a wide bandwidth from a low frequency to a high frequency.

In the electromagnetic wave shielding material according to the present disclosure, when the magnetic layer is the ferrite sintered plate, the magnetic layer preferably further includes adhesive layers or protecting layers on both the surfaces of the ferrite sintered plate, the ferrite sintered plate is preferably divided into small pieces, and the electromagnetic wave shielding material is preferably bendable into a tubular shape.

In this configuration, the ferrite sintered plate is divided into small pieces, and therefore, the magnetic layer can have the flexibility to a bend and a warp. Thus, when applied to, for example, a cable, the electromagnetic wave shielding material can be bent into a tubular shape to wrap around the outer periphery of, for example, the cable.

### ADVANTAGEOUS EFFECTS OF INVENTION

The electromagnetic wave shielding material according to the present invention enables the magnetic field shielding effect in a wide frequency range to be enhanced.

### BRIEF DESCRIPTION OF DRAWINGS

[FIG. 1] FIG. 1 is a top perspective view of an electromagnetic wave shielding material according to an embodiment of the present invention.
[FIG. 2] FIG. 2 is a sectional view of the electromagnetic wave shielding material according to the embodiment of the present invention taken along line II-II of FIG. 1.
[FIG. 3] FIG. 3 is a top perspective view of an electromagnetic wave shielding material according to a variation of the embodiment of the present invention.
[FIG. 4] FIG. 4 is a sectional view of the electromagnetic wave shielding material according to the variation of the embodiment of the present invention taken along line IV-IV of FIG. 3.
[FIG. 5] FIG. 5 is a top perspective view of an electromagnetic wave shielding material according to another variation of the embodiment of the present invention.
[FIG. 6] FIG. 6 is a sectional view of the electromagnetic wave shielding material according to the another variation of the embodiment of the present invention taken along line VI-VI of FIG. 5.
[FIG. 7] FIG. 7 is a view of magnetic field shielding properties of shielding materials of examples.
[FIG. 8] FIG. 8 is a view of magnetic field shielding properties of shielding materials of an example and comparative examples.

### DESCRIPTION OF EMBODIMENTS

An embodiment of the present invention will be described below with reference to the drawings. The description of the following preferable embodiment is substantially a mere example and does not intend to limit the present invention, the application method of the present invention, or the application of the present invention.

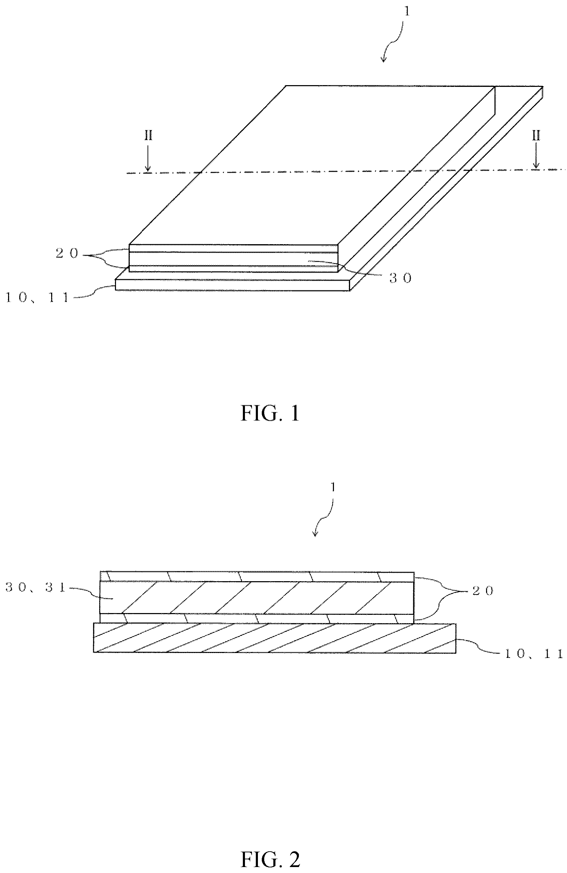

First of all, an electromagnetic wave shielding material according to an embodiment of the present invention will be described with reference to FIGS. 1 and 2. FIG. 1 is a top perspective view of an electromagnetic wave shielding material 1, and FIG. 2 is a sectional view taken along line II-II of FIG. 1. As shown in FIGS. 1 and 2, the electromagnetic wave shielding material 1 according to the present embodiment includes: a magnetic layer 30 including a magnetic material; and conductive meshes 20 disposed on both surfaces of the magnetic layer 30, wherein the conductive mesh 20, the magnetic layer 30, and the conductive mesh 20 are sequentially stacked in this order. The electromagnetic wave shielding material 1 may be held by a base material 10.

The base material 10 may have a conductive layer 11 formed from an electrically conductive material on the surface thereof. The base material 10 itself may be the conductive layer 11 as shown in FIG. 2, or the base material 10 may be a laminated body including: a resin sheet, such as polyethylene terephthalate (PET); and the conductive layer 11 stacked on a surface of the resin sheet. In this case, the conductive layer 11 may be stacked on an adhesive material provided on the resin sheet, such as PET, as the base material 10.

The electrically conductive material used for the conductive layer 11 is not limited to a particular material but may be, for example, a metal foil such as an aluminum foil and an alloy foil.

As the magnetic layer 30, a magnetic sheet may be used. Examples usable as the magnetic sheet include a ferrite sintered plate, an alloy plate, a sheet-shaped item obtained by molding a mixture of ferrite or metal magnetic powder and resin or rubber, and a base material coated with a coating material including magnetic powder. Examples of a soft magnetic material of the sheet include a Ni-Zn-Cu ferrite, a Mn-Zn ferrite, an amorphous alloy, Permalloy, electromagnetic steel, silicon steel, a sendust alloy, a Fe-Si alloy, a Fe-Al alloy, carbonyl iron, and reduced iron. Examples of a hard magnetic material of the sheet include a magnetoplumbite ferrite. The magnetic sheet is particularly preferably a sheet including the ferrite sintered plate.

The thickness of the magnetic layer 30 is not limited to a particular thickness but is preferably less than or equal to 5 mm when the electromagnetic wave shielding material is formed into a sheet. When the electromagnetic wave shielding material is formed into a flexible sheet, the thickness of the magnetic layer 30 is preferably 30 µm to 300 µm, more preferably 50 µm to 100 µm.

Each of the conductive meshes 20 is preferably formed by braiding metal wires and is preferably in the shape of a flat plate which is to be disposed on the magnetic layer 30. Using the conductive meshes 20 formed by braiding the metal wires can reduce the weight of the electromagnetic wave shielding material 1 while the electromagnetic wave shielding material 1 can be resistant to fracture or the like caused by deformation and can have excellent flexibility. Thus, when applied to, for example, a cable, the electromagnetic wave shielding material 1 can be bent into a tubular shape to wrap around the outer periphery of, for example, the cable. A material for the metal wires used is not limited to a particular material but may be, for example, a metal material such as copper, a copper alloy, aluminum, and an aluminum alloy.

The conductive meshes 20 are each preferably disposed close to the magnetic layer 30. The effect of the present invention can be exhibited as long as the conductive meshes 20 are disposed on both the surfaces of the magnetic layer 30, but disposing the conductive meshes 20 close to the magnetic layer 30 further increases the effect of enhancing the magnetic field shielding performance.

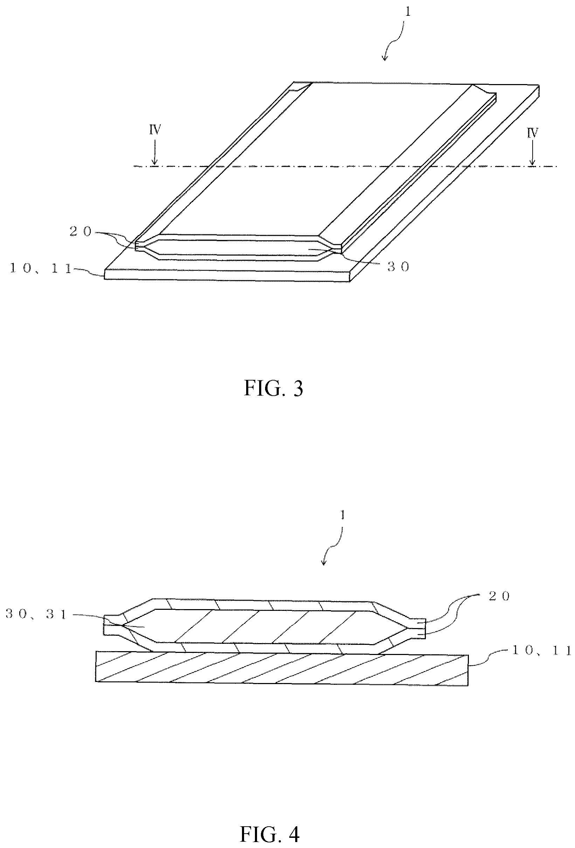

With reference to FIGS. 3 and 4, an electromagnetic wave shielding material according to a variation of the embodiment of the present invention will be described. Note that differences from the embodiment described above will be described here, and the description of similar matters to those of the embodiment described above will be omitted. FIG. 3 is a top perspective view of an electromagnetic wave shielding material 1, and FIG. 4 is a sectional view taken along line IV-IV of FIG. 3. As shown in FIGS. 3 and 4, the electromagnetic wave shielding material 1 according to the variation of the present embodiment includes: a magnetic layer 30 including a magnetic material; and conductive meshes 20 disposed on both surfaces of the magnetic layer 30. Here, the conductive meshes 20 on both the surfaces are each larger than the magnetic layer 30, and the conductive meshes 20 are in contact with each other at both ends of the magnetic layer 30 in a width direction such that the conductive mesh 20 on the one of both the surfaces and the conductive mesh 20 on the other of both the surfaces are conductively connected to each other. Note that the conductive meshes 20 may be in contact with each other at both ends of the magnetic layer 30 in a longitudinal direction such that the conductive mesh 20 on the one of both the surfaces and the conductive mesh 20 on the other of both the surfaces are conductively connected to each other.

In the electromagnetic wave shielding material 1 according to the variation of the present embodiment, it suffices that the conductive meshes 20 disposed on both the surfaces of the magnetic layer 30 are conductively connected to each other. The conductive meshes 20 on both the surfaces may be connected to each other by direct contact or may be connected to each other via an electrically conductive joint member. Moreover, the conductive meshes 20 disposed on the electromagnetic wave shielding material 1 in advance may be made conductive at both ends of a magnetic body by deformation due to use of the electromagnetic wave shielding material 1. This enables surroundings of the magnetic layer 30 to continuously be made electrically conductive, and thus, noises are less likely to leak. This can enhance the electromagnetic field shielding effect of the electromagnetic wave shielding material 1 at a high frequency. Moreover, when the conductive meshes on both the surfaces are joined, the conductive meshes can easily be connected to ground (GND), and therefore, the number of GND lines can be reduced.

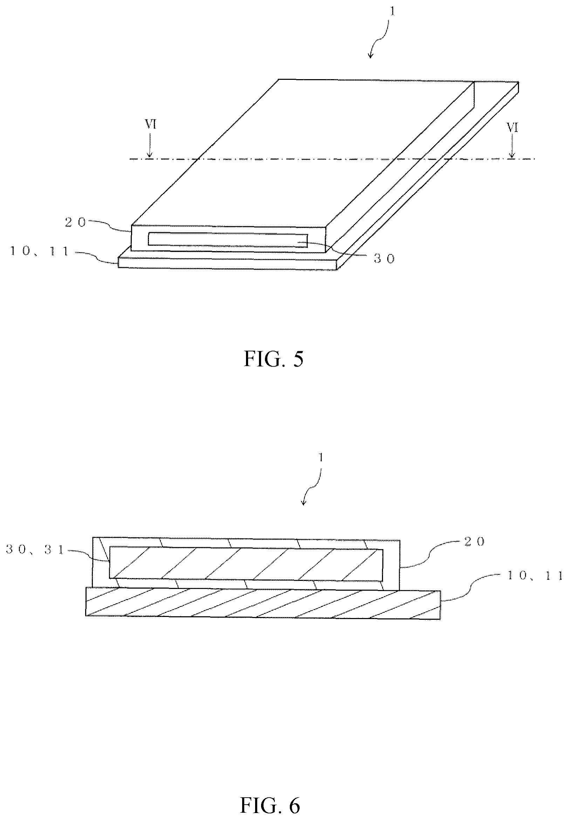

With reference to FIGS. 5 and 6, an electromagnetic wave shielding material according to another variation of the embodiment of the present invention will be described. Note that differences from the embodiment described above will be described here, and the description of similar matters to those of the embodiment described above will be omitted. FIG. 5 is a top perspective view of an electromagnetic wave shielding material 1, and FIG. 6 is a sectional view taken along line VI-VI of FIG. 5. As shown in FIGS. 5 and 6, the electromagnetic wave shielding material 1 according to the another variation of the present embodiment includes: a base member 10 having a sheet shape; and a conductive mesh 20 disposed on a surface of the base member 10 and having a tubular or bag shape. A magnetic layer 30 including a magnetic material is housed inside the conductive mesh 20.

In FIGS. 5 and 6, the conductive mesh 20 is shown such that each of surfaces of the conductive mesh 20 has a flat plate shape for the sake of simplification. However, the conductive mesh 20 is actually metal wires braided into a tubular or bag shape, and a material for the metal wires used is not limited to a particular material but may be, for example, a metal material such as copper, a copper alloy, aluminum, and an aluminum alloy. In the present embodiment, both ends of the conductive mesh 20 in the width direction are closed and one end of the conductive mesh 20 in the longitudinal direction is also closed, while the conductive mesh 20 has an opening at the other end in the longitudinal direction as shown in FIGS. 5 and 6. Thus, the magnetic layer 30 can be inserted through the opening into the conductive mesh 20. Note that both the ends of the conductive mesh 20 in the longitudinal direction may have openings. Further, both the ends of the conductive mesh 20 in the longitudinal direction may be closed after the magnetic layer 30 is housed in the conductive mesh 20.

In the electromagnetic wave shielding material 1 according to the another variation of the present embodiment, the conductive mesh 20 has the tubular or bag shape as described above, and as shown in FIG. 5, the magnetic layer 30 is housed inside the conductive mesh 20. This enables surroundings of the magnetic layer 30 to continuously be made electrically conductive, and thus, noises are less likely to leak. This can enhance the magnetic field shielding effect of the electromagnetic wave shielding material 1. Thus, in the electromagnetic wave shielding material 1 according to the another variation of the present embodiment, a synergetic effect of the conductive mesh 20 and the magnetic layer 30 enables the magnetic field shielding effect to be enhanced in a wide frequency range. Moreover, since the magnetic layer 30 is housed inside the conductive mesh 20 having the tubular or bag shape, the conductive mesh 20 and the magnetic layer 30 do not have to be fixed to each other and can be stacked one on top of another while the degree of freedom of moving relative to each other is maintained. Therefore, the electromagnetic wave shielding material 1 can be resistant to fracture or the like caused by deformation and can have excellent flexibility. Thus, when applied to, for example, a cable, the electromagnetic wave shielding material 1 can easily be bent into a tubular shape to wrap around the outer periphery of, for example, the cable.

Further, in the present embodiment and the variations thereof, the magnetic material is preferably a ferrite sintered plate 31. The ferrite sintered plate 31 is a ferrite sintered body formed into a plate shape. The type of the ferrite used is not limited to a particular type as long as it has a magnetic property. For example, soft magnetic ferrite such as a Ni-Zn-based ferrite and a Mn-Zn-based ferrite and hard magnetic ferrite such as a magnetoplumbite ferrite may be used. A method for manufacturing the ferrite sintered plate 31 is also not limited to a particular method. For example, a method may be used which includes applying a ferrite-dispersion coating material to a plastic film to obtain a ferrite molded sheet, and sintering the ferrite molded sheet to obtain a ferrite sintered body.

In the present embodiment and the variations thereof, when the magnetic material is the ferrite sintered plate 31, the magnetic layer 30 preferably further includes adhesive layers or protecting layers disposed on both surfaces of the ferrite sintered plate 31, that is, on a top surface of the ferrite sintered plate 31, the adhesive layer or the protecting layer is disposed, and also on a back surface of the ferrite sintered plate 31, the adhesive layer or the protecting layer is disposed, and the ferrite sintered plate 31 is preferably divided into small pieces. With this configuration, the magnetic layer 30 can have the flexibility to a bend and a warp. Further, the electromagnetic wave shielding material 1 is preferably bendable into a tubular shape. Thus, when applied to, for example, a cable, the electromagnetic wave shielding material 1 can be bent into a tubular shape to wrap around the outer periphery of, for example, the cable.

The adhesive layer is not particularly limited to a particular layer but may be, for example, a known double-stick tape including a PET film or a polyimide film as a base material, or including no base material. The protecting layer is not limited to a particular layer as long as it is an expandable and contractable resin without fracture when the ferrite sintered plate 31 is bent, and for example, a resin material such as PET may be used.

In order to divide the ferrite sintered body into small pieces, predetermined split grooves may be formed in the ferrite molded sheet. The split grooves may be continuous or intermittent or may be a large number of fine recesses as an alternative. The ferrite sintered plate 31 is divided along the split grooves formed in advance into pieces having a triangular shape, a quadrangular shape, a polygonal shape, or a shape of a combination thereof, having an arbitrary size. Alternatively, the ferrite sintered plate 31 may be divided into pieces having irregular shapes without forming the split grooves.

As described above, in the electromagnetic wave shielding material 1 according to the present embodiment and the variations thereof, the magnetic layer 30 including the magnetic material is sandwiched within the conductive mesh(es) 20 as described above, and thus, both the surfaces of the magnetic layer 30 are electrically conductive. This suppresses noises from leaking and can thus enhance the magnetic field shielding effect of the electromagnetic wave shielding material 1. Thus, in the electromagnetic wave shielding material 1 according to the present embodiment, a synergetic effect of the conductive meshes 20 and the magnetic layer 30 enables the magnetic field shielding effect to be enhanced in a wide frequency range.

### EXAMPLES

Examples of the application of the present invention and the comparative examples thereof will be described below. The present examples are to illustrate the present invention but should not be construed as limiting the scope of the invention.

### Example 1

A magnetic layer was obtained by disposing resin sheets on adhesive layers provided on both surfaces of a ferrite sintered plate having a size of 7 cm × 20 cm and a thickness of 200 µm, the ferrite sintered plate being divided into small pieces. The magnetic layer was sandwiched within two conductive meshes each having a size of 7 cm × 20 cm, thereby obtaining an electromagnetic wave shielding material. The electromagnetic wave shielding material was stacked on a resin sheet base material.

### Example 2

A magnetic layer was obtained by disposing resin sheets on adhesive layers provided on both surfaces of a ferrite sintered plate having a size of 7 cm × 20 cm and a thickness of 200 µm, the ferrite sintered plate being divided into small pieces. The magnetic layer was sandwiched within two conductive meshes each having a size of 8 cm × 21 cm, thereby obtaining an electromagnetic wave shielding material. The electromagnetic wave shielding material was stacked on a resin sheet base material.

### Example 3

A tubular body formed from a conductive mesh and having an outer periphery of 16 cm and a length of 20 cm was pressed to have a flat plate shape, within which a magnetic layer obtained by disposing resin sheets on adhesive layers provided on both surfaces of a ferrite sintered plate having a size of 7 cm × 20 cm and a thickness of 200 µm was sandwiched, the ferrite sintered plate being divided into small pieces. Thereby, an electromagnetic wave shielding material was obtained, which was stacked on a resin sheet base material.

### Reference Example 1

A tubular body formed from a conductive mesh and having an outer periphery of 16 cm and a length of 20 cm was pressed into a shape of a flat plate and was then stacked on a resin sheet base material.

### Reference Example 2

A magnetic layer was obtained by disposing resin sheets on adhesive layers provided on both surfaces of a ferrite sintered plate having a size of 7 cm × 20 cm and a thickness of 300 µm, the ferrite sintered plate being divided into small pieces. The magnetic layer was stacked on a resin sheet base material.

### Example 4

The tubular body used in Reference Example 1, formed from the conductive mesh, and having an outer periphery of 16 cm and a length of 20 cm was pressed to have a flat plate shape, within which the magnetic layer including the ferrite sintered plate, used in Reference Example 2 and having a size of 7 cm × 20 cm and a thickness of 300 µm, was sandwiched, thereby obtaining an electromagnetic wave shielding material. The electromagnetic wave shielding material was stacked on a resin sheet base material.

### Comparative Example 1

The tubular body used in Reference Example 1, formed from the conductive mesh, and having an outer periphery of 16 cm and a length of 20 cm was pressed to have a flat plate shape, on which the magnetic layer including the ferrite sintered plate having a size of 7 cm × 20 cm and a thickness of 300 µm used in Reference Example 2 was stacked, thereby obtaining an electromagnetic wave shielding material. A resin sheet base material was further stacked on a surface opposite to the ferrite sintered plate.

### Comparative Example 2

The tubular body used in Reference Example 1, formed from the conductive mesh, and having an outer periphery of 16 cm and a length of 20 cm was pressed to have a flat plate shape, on which the ferrite sintered plate used in Reference Example 2 and having a size of 7 cm × 20 cm and a thickness of 300 µm was stacked, thereby obtaining an electromagnetic wave shielding material. A resin sheet base material was further stacked on a surface provided with the ferrite sintered plate.

### <Evaluation of Magnetic Field Shielding Property>

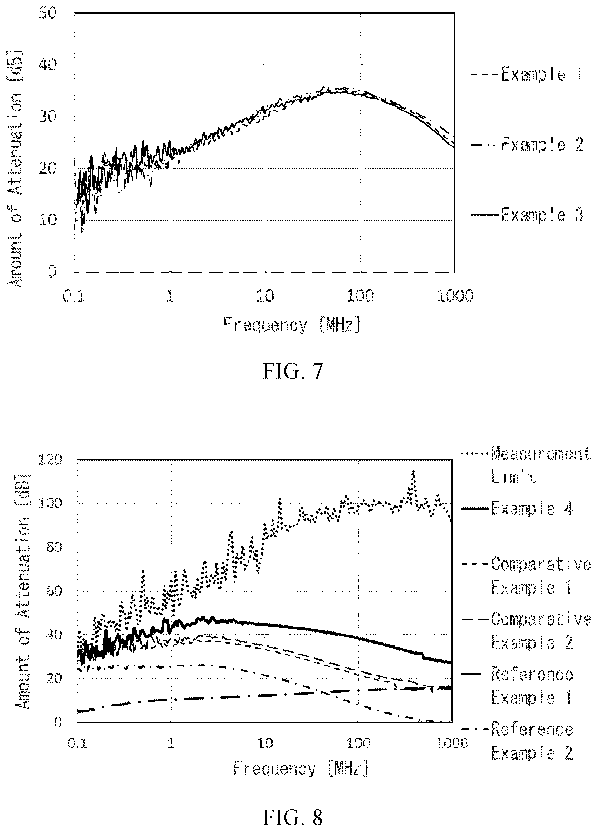

Magnetic field shielding properties of the shielding materials of the examples and the comparative examples were measured by a KEC method. This measurement method is a method developed by KEC Electronic Industry Development Center (KEC). In this method, a flat plate sample (60 mm × 60 mm square or larger) is measured by being sandwiched within a device for measuring a magnetic near-field shielding effect. In the measurement at this time, the measurement was performed with the resin sheet base material arranged on an opposite side of a noise source. The measurement frequency was from 100 kHz to 1000 MHz. Evaluation results of the shielding materials obtained in the examples and comparative examples are shown in FIGS. 7 and 8.

As shown in FIG. 7, the electromagnetic wave shielding material of each of Examples 1 to 3 exhibited an excellent magnetic field shielding effect in a frequency range from 0.1 MHz to 1 GHz. Moreover, as shown in FIG. 8, it was revealed that in the electromagnetic wave shielding material of each of the examples, the magnetic layer including the ferrite sintered plate is sandwiched within the conductive mesh(es), thereby exhibiting an excellent magnetic field shielding effect as compared with each comparative example. Thus, the electromagnetic wave shielding material of each example enables the magnetic field shielding effect in a wide frequency range to be enhanced. Therefore, it is inferred that the electromagnetic wave shielding material of each example can suitably be used as an electromagnetic wave shielding material that can shield the magnetic field in a wide frequency range.

Thus, the electromagnetic wave shielding material according to the present invention enables the magnetic field shielding effect in a wide frequency range to be enhanced and is thus useful.

### DESCRIPTION OF THE REFERENCE CHARACTERS

- 1: Electromagnetic Wave Shielding Material
- 10: Base Material
- 11: Conductive Layer
- 20: Conductive Mesh
- 30: Magnetic Layer
- 31: Ferrite Sintered Plate

## Claims

1. An electromagnetic wave shielding material comprising:
a magnetic layer including a magnetic material; and
conductive meshes disposed on both surfaces of the magnetic layer.

2. The electromagnetic wave shielding material of claim 1, wherein
the conductive mesh disposed on one of both the surfaces and the conductive mesh disposed on the other of both the surfaces are conductively connected to each other at both ends of the magnetic layer in a longitudinal direction or a width direction.

3. The electromagnetic wave shielding material of claim 2, wherein
the conductive meshes are provided as a conductive mesh having a tubular or a bag shape, and
the magnetic layer is housed inside the conductive mesh.

4. The electromagnetic wave shielding material of any one of claims 1 to 3, wherein
the magnetic material is a ferrite sintered plate.

5. The electromagnetic wave shielding material of claim 4, wherein
the magnetic layer further includes adhesive layers or protecting layers on both the surfaces of the ferrite sintered plate,
the ferrite sintered plate is divided into small pieces, and
the electromagnetic wave shielding material is bendable into a tubular shape.
